# EUROPEAN PATENT APPLICATION

(11) **EP 1 006 130 A1**
(43) Date of publication of application: **07.06.2000**
(21) Application number: 99309559.5
(22) Date of filing: 29.11.1999
(51) Int. Cl.: C08F 22/10, C08L 35/02

(54) **Fumaric acid diester resin composition, cross-linked fumaric acid diester resin and process**

(30) Priority: 30.11.1998 US 339098
(71) Applicant: NOF CORPORATION, Tokyo 150-0013 (JP); TDK Corporation, Chuo-ku, Tokyo 103-8272 (JP)
(72) Inventor: Amaya, Naoyuki, NOF Corporation, Chita-gun, Aichi-ken 470-2345 (JP); Katoh, Yukihiro, Nof Corporation, Chita-gun, Aichi-ken 470-2345 (JP); Imamura, Yasuhiro, Tsukuba-shi, Ibaraki-ken 300-2635 (JP); Yamada, Toshiaki, Turugashima-shi, Saitama-ken 350-2211 (JP); Hasegawa, Hiroaki, Abiko-shi, Chiba-ken 270-1112 (JP); Asami, Shigeru, Yotukaido-shi, Chiba-ken 284-0024 (JP)
(74) Representative: Browne, Robin Forsythe, Dr.

(57) **Abstract**

A fumaric acid diester resin composition including a resin containing a fumaric acid diester monomer, an organic peroxide and an organic solvent. When this resin composition is heated, cross-linking occurs across the resin. The resulting crosslinked resin has low dielectric constant and excellent heat resistance, solvent resistance and chemical resistance.

## Description

### BACKGROUND OF THE INVENTION

The present invention relates to a cross-linked fumaric acid diester resin and a fumaric acid diester resin composition that is a raw material of the cross-linked fumaric acid diester resin. More particularly, the present invention relates to a cross-linked fumaric acid diester resin that is used for electronic component materials such as a printed wiring board insulating material, a printed wiring board impregnation resin, an insulating varnish, an electronic component coating material and an electronic component potting material.

Recently, electronic equipment in the high-frequency band communications field have rapidly become more compact. Accompanying the reduction in size, electronic component materials are being required to resist solvents, chemicals, and heat. Furthermore, such materials require dimensional stability and favorable electrical characteristics. In particular, there is a strong demand for materials having low energy losses. If materials having low dielectric losses can be used in electronic components, signal delays in electronic devices and heat generation due to dielectric losses are reduced, which results in fewer misoperations.

Epoxy resins have so far been used in, for example, printed wiring boards such as copper-clad laminated boards. However, epoxy resins have the high dielectric characteristics at high frequencies, which is a disadvantage. In addition, polyimide resins are also used in flexible printed wiring boards. Polyimide resins have a superior balance between mechanical performance and thermal performance. However, polyimide resins have poor dielectric characteristics and high hygroscopic properties.

Thermoplastic resin films such as polyphenylene sulfide and polyether imide have been developed to improve the prior art materials. Although thermoplastic resin films have a low hygroscopic property, they have poor heat resistance. As a result, when a thermoplastic resin film is used continuously at high temperatures, the electrical characteristics (dielectric loss, dielectric constant, etc.) of the thermoplastic resin film deteriorate. Thus, these thermoplastic resin films are not suitable for use as insulating materials.

Thermosetting resins including bismaleimide-triazine (BT) resins, polyphenylene ether resins (polyphenylene oxides), unsaturated polyester resins, polyamidoimides and phenol resins have been proposed and used to improve the above-mentioned shortcomings of high-frequency components. On the other hand, although fluorine resins have excellent solvent resistance and electrical characteristics, processing of fluorine resins is difficult. In addition, fluorine resins have low adhesivity to materials such as metal and are also expensive. Consequently, the use of fluorine resins in high-frequency components is currently limited.

In order to solve the above-mentioned problems, Japanese Unexamined Patent Publication No. 9-208627 discloses polyfumaric acid diesters for use in electronic components. Since polyfumaric acid diesters have low dielectric constants, low dielectric loss characteristics and excellent heat resistance, they are useful as insulating materials for high-frequency band components.

A fumaric acid diester polymer or a copolymer of fumaric acid diester with styrene or vinyl acetate is used in the high-frequency substrate and electronic component of Japanese Unexamined Patent Publication No. 9-208627. Since each of these polymers are linear polymers, they are not thermoplastic. Consequently, these polymers cannot be processed by hot molding or injection molding. Therefore, a method is used wherein a polyfumaric acid diester resin solution is formed into a sheet or block by solvent casting to form a primary product, followed by cutting and the like to obtain a finished electronic component. Incidentally, the solvent casting refers to a method by which a polymer is obtained by gradually evaporating a solvent in a polymer solution. For example, a polymer solution is coated onto a substrate such as glass, and then the solvent is gradually evaporated. As a result, a transparent polymer film is obtained.

In the production of electronic components using polyfumaric acid diesters, a polyfumaric acid diester is dispersed and dissolved in an organic solvent, and a solvent casting step is performed. Consequently, there are problems in terms of the productivity and quality. Since films and laminated substrates obtained by solvent casting do not have solvent resistance, the organic solvents that can be used during their production into electronic components are limited. In addition, the polymers and copolymers described in Japanese Unexamined Patent Publication No. 9-208627 are easily attacked by organic solvents and chemicals such as acids and alkalis, thereby limiting their applications.

### SUMMARY OF THE INVENTION

The object of the present invention is to provide a cross-linked fumaric acid diester resin having a low dielectric constant, heat resistance, solvent and chemical resistance, and a fumaric acid diester resin composition having as its raw material the cross-linked fumaric acid diester resin.

In order to achieve the above-mentioned object, a first aspect of the present invention provides a fumaric acid diester resin composition containing a polymer having at least one kind of fumaric acid diester monomer (fumaric acid diester resin), an organic peroxide and an organic solvent.

Another aspect of the present invention provides a production method of cross-linked fumaric acid diester resins. That production method includes preparing a composition containing a polymer, which has at least one kind of fumaric acid diester monomer (fumaric acid diester resin), an organic peroxide, and an organic solvent. The method further includes evaporating the organic solvent and heating the product obtained in the evaporation step.

Features of the present invention thought to be novel will be made apparent particularly in the appended claims. The present invention as well as its object and advantages will be understood from the description of embodiments and examples that are presently preferred.

### DETAILED DESCRIPTION OF THE PREFERRED EMBODIMENTS

A first embodiment of the present invention will be described below.

The fumaric acid diester resin composition of the present invention includes a fumaric acid diester resin, an organic peroxide and an organic solvent. An organic peroxide is used because it reacts with the fumaric acid diester resin to form a cross-linked product. The fumaric acid diester resin is the main component of this composition and is a polymer that is obtained by polymerizing a monomer composition having at least one kind of fumaric acid diester monomer. The fumaric acid diester resin or its polymer indicates a polymer having at least one kind of fumaric acid diester monomer herein.

Although there are no particular restrictions on the fumaric acid diester monomer provided it is a compound that yields a polymer having low dielectric characteristics and heat resistance, a compound represented by the following chemical formula (1) is preferred:

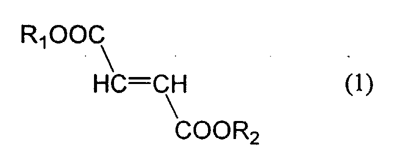

In formula (1), R₁ represents a branched alkyl group or a cycloalkyl group having 3 to 18 carbon atoms, preferably 3 to 8 carbon atoms. R₂ represents an alkyl group, a cycloalkyl group or an aryl group having 3 to 18 carbon atoms, preferably 3 to 8 carbon atoms, and R₁ and R₂ may be the same or different from each other.

If R₁ and R₂ each are a branched alkyl group, they may have a substituent group, examples of which include a halogen group (such as F or Cl) and an alkoxy group (such as a methoxy group, an ethoxy group, a propoxy group or a butoxy group).

Examples of R₁ and R₂ when they represent an alkyl group include an isopropyl group, a sec-butyl group, a tert-butyl group, a sec-amyl group, a neopentyl group, a tert-amyl group, a 4-methyl-2-pentyl group, a hexafluoroisopropyl group and a perfluoro-tert-butyl group.

If R₁ and R₂ are each a cycloalkyl group, they may have a single ring or bridged rings, and they may also have a substituent group. A branched alkyl group is preferred as the substituent group.

Examples of R₁ and R₂ when they represent a cycloalkyl group include a cyclopentyl group, a cyclohexyl group, a bornyl group, an isobornyl group, an adamantyl group and a dimethyladamantyl group.

Examples of R₂ when it represents an aryl group include a phenyl group. The aryl group may have a substituent group. For example, a 4-methylphenyl group and a 4-tert-butylphenyl group can be used as the aryl group.

Specific preferred examples that can be used as the fumaric acid diester monomer represented by formula (1) include dialkyl fumarates such as diisopropyl fumarate, di-sec-butyl fumarate, di-tert-butyl fumarate, diisobutyl fumarate, di-sec-amyl fumarate, di-tert-amyl fumarate, isopropyl-sec-butyl fumarate, tert-butyl-4-methyl-2-pentyl fumarate, isopropyl-tert-butyl fumarate, isopropyl-sec-butyl fumarate, isopropyl-sec-amyl fumarate, di-4-methyl-2-pentyl fumarate, di-4-methyl-2-hexyl fumarate and tert-butyl-isoamyl fumarate; dicycloalkyl fumarates such as dicyclohexyl fumarate, dicyclopentyl fumarate, dicycloheptyl fumarate, dicyclooctyl fumarate, cyclopentylcyclohexyl fumarate, diadamantyl fumarate, bis(dimethyl)adamantyl fumarate, bornyl fumarate and isobornyl fumarate; alkylcyclohexyl fumarates such as isopropyl-cyclohexyl fumarate, isopropyl-dimethyladamantyl fumarate, isopropyladamantyl fumarate and tert-butyl-cyclohexyl fumarate; alkylfluoroalkyl fumarates such as bis-hexylfluoroisopropyl fumarate, isopropyl-perfluorooctylethyl fumarate and isopropylhexafluoroisopropyl fumarate; and substituted alkyl-alkyl fumarates such as l-butoxy-2-propyl-tert-butyl fumarate, methoxyethyl-isopropyl fumarate and 2-chloroethyl-isopropyl fumarate.

Among them, diisopropyl fumarate, dicyclohexyl fumarate, di-sec-butyl fumarate, di-tert-butyl fumarate, isopropyl-tert-butyl fumarate, isopropyl-sec-butyl fumarate, isopropylcyclohexyl fumarate, sec-butylcyclohexyl fumarate and tert-butylcyclohexyl fumarate are particularly preferable since they can be easily synthesized and their polymerization reactions are also easily carried out.

There are no restrictions on the polymerized form of the fumaric acid diester polymer. The fumaric acid diester polymer may include, for example, a homopolymer derived from one kind of fumaric acid diester monomer, an alternating copolymer derived from two kinds of fumaric acid diester monomers, a random copolymer and a block copolymer derived from a plurality of fumaric acid diester monomers, or a mixture of those copolymers. Also, a copolymer composed of at least one kind of fumaric acid diester monomer and a vinyl monomer that can be copolymerized with the monomer can also be used.

There are no particular restrictions on the molecular weight of the fumaric acid diester polymer. This polymer can be used as an insulating film, and an electrical insulating substrate can be formed by laminating this film. In this case, since it is necessary that the resulting substrate have enough mechanical strength to withstand the stress produced during production of electronic components, the molecular weight of the polymer is preferably relatively high, and the weight average molecular weight is preferably 100,000 to 1,600,000.

If the weight average molecular weight is less than 100,000, the resulting product lacks mechanical strength, chemical stability, and heat resistance. Moreover, it is difficult to produce a resin film with such a polymer, and even if such a resin film could be produced, it would have low adhesion with a substrate. In addition, cracks would occur easily inside the product. On the other hand, if the weight average molecular weight exceeds 1,600,000, the intrinsic viscosity of the polymer solution increases rapidly. Consequently, it would become difficult to produce a uniform and smooth film and would significantly decrease workability and productivity. Further, since highly viscous solutions hardly penetrate inside fibers, it would be difficult to produce a composite substrate by impregnating a glass fiber with the fumaric acid diester resin composition.

If the monomer composition includes at least one kind of fumaric acid diester monomer and vinyl monomer, it is preferred that the fumaric acid diester monomer is at least 50 wt%, and preferably at least 80 wt%, of the monomer composition.

This is because the fumaric acid diester homopolymer differs from a vinyl polymer, which is a thermoplastic resin, in that it is relatively heat resistant, and has excellent acid and alkali resistance (etching resistance). Thus, if the amount of fumaric acid diester is too small, the electrical characteristics (namely dielectric constant, dielectric loss tangent and dielectric loss) and heat resistance of the resulting polymer become inadequate. The heat resistance of fumaric acid diester resin is probably due to the molecular structure of fumaric acid diester resin being in the form of a rod of low curvature, which results in a low level of thermal mobility. The acid and base resistance of fumaric acid diester resin is probably the result of inhibiting the attack by chemicals on ester bonds of the side chain groups in fumaric acid diester resin.

Dielectric loss tangent and dielectric loss are defined in the manner described below.

If a dielectric is treated as a single condenser, when an alternating current voltage is applied to that dielectric, the phase difference angle (θ) between voltage and current if the dielectric is an ideal condenser would be a perfect 90° and the energy loss would be zero. However, since that phase difference angle θ is slightly offset from 90° in the case of a typical dielectric, a small amount of current flows and energy is lost. This energy loss is referred to as dielectric loss. In addition, the angle of the shift from 90° of the phase difference angle (θ) is expressed with δ, and the tangent (tan δ) of that shift angle (δ) is the dielectric loss tangent.

On the other hand, the percentage of vinyl monomer in the monomer composition is preferably zero to 50 wt% and more preferably, zero to 20 wt%. Examples of vinyl monomers that can be used include styrene derivatives, butadiene derivatives, vinyl or allyl ethers, branched fatty acid vinyl or allyl esters, and aromatic vinyl carboxylate or allyl esters.

The content of fumaric acid diester resin in the fumaric acid diester resin composition is preferably 5 to 30 wt%. This content is suitably selected according to film formability, substrate coatability and glass fiber adhesion (impregnation). In the case the content is less than 5 wt%, the composition lacks adhesion. On the other hand, if the content is greater than 30 wt%, there is no particular improvement in adhesion and the mechanical properties of the formed film decrease. It is more preferable that the content of fumaric acid diester resin be 10 to 20 wt%.

The purpose of obtaining a cross-linked product by heating the fumaric acid diester resin composition is described below. Since the fumaric acid diester resin is soluble in an organic solvent, the resin dissolves if it contacts organic resin even in the case of electronic components produced by solvent casting. Therefore, cross-linking by the covalent bonds between polymer chains improves the solvent resistance and chemical resistance of the fumaric acid diester resin. While various methods are available for cross-linking, cross-linking using a radical catalyst is most effective since it does have a negative effect on the electrical characteristics. A method using organic peroxide is particularly effective from the viewpoints of reaction stability and workability.

When a mixture of organic peroxide and polymer is heated, the organic peroxide generates primary radicals due to thermal decomposition. These primary radicals abstract the hydrogen atoms in the main chain or side chains of the polymer resulting in the formation of polymer radicals. The resulting polymer radicals mutually form the cross-linked bond by coupling reaction. As a result, cross-linked fumaric acid diester resin is obtained. The resulting cross-linked fumaric acid diester resin (fumaric acid diester resin cross-linked product) has excellent resistance to heat, solvents, chemicals, acids, and alkalis. In addition, the dielectric loss of the cross-linked product is low.

All known organic peroxides can be used for the organic peroxide provided that the free radicals formed by primary decomposition have the ability to abstract hydrogen atoms from the polymer. Those having high efficiency in hydrogen abstraction and those that do not require a high temperature during reaction are particularly preferable. For example, organic peroxides for which the 10-hour half-life temperature is 30 to 230°C are preferable, while organic peroxides for which the above-mentioned temperature is 80 to 200°C are more preferable.

Examples of these organic peroxides include 1,1-bis(tert-butylperoxy)cyclohexane, di-tert-butyl peroxide, tert-butylcumyl peroxide, dicumyl peroxide, 2,5-dimethyl-2,5-di(tert-butylperoxy)hexane, 2,5-dimethyl-2,5-di(tert-butylperoxy)hexyne-3,α,α-bis(tert-butylperoxy)diisopropyl-benzene, tert-butylperoxy-2-ethylhexanoate, tert-butyl peroxydiisobutylate, cumene peroxide, tert-butyl peroxypivalate, lauroyldiacyl peroxide, 2,4-dichlorobenzoyl peroxide, m-toluoyl peroxide, benzoyl peroxide, 2,5-dimethyl-2,5-bis(benzoylperoxy)hexane, tert-butyl peroxy-m-toluoylbenzoate, tert-butyl peroxybenzoate, 1,1-bis(tert-butylperoxy-3,3,5-trimethylcyclohexane, dicumyl peroxide, 2,5-dimethyl-2,5-bis(tert-butylperoxy)hexane, tert-butylcumyl peroxide and tert-butyl peroxide.

At least one of the organic peroxides selected from the above-mentioned group is used. The amount of organic peroxide used is preferably 1 to 15 parts by weight, more preferably 2 to 5 parts by weight, to 100 parts by weight of fumaric acid diester resin.

Organic solvents in which fumaric acid diester resin substantially dissolves can be used for the solvent. Examples of the organic solvents include aromatic hydrocarbon-based solvents such as benzene, toluene and xylene, ketone-based solvents such as acetone, methyl ethyl ketone, methyl isobutyl ketone and cyclohexanone as well as tetrahydrofuran (THF), acetonitrile, methylene chloride, chloroform, dimethylformamide, dimethyl sulfoxide, butyl chloride, ethyl acetate, butyl acetate, decalin and trichloroethane.

A fumaric acid diester resin composition is obtained if a fumaric acid diester resin is dissolved in these organic solvents followed by mixing with the above-mentioned organic peroxides. Hydrocarbon-based organic solvents having a relatively high boiling point such as toluene, xylene and butyl acetate are preferable. In addition, a solvent consisting of a mixture of two or more kinds of solvents may also be used in order to control the evaporation rate.

The organic solvent preferably makes up 50 to 98 wt% of the fumaric acid diester resin composition. If the organic solvent content is less than 50 wt%, it becomes extremely difficult to dissolve the resin composition, and the viscosity becomes extremely high. Consequently, it becomes difficult to process the composition. On the other hand, if the organic solvent content exceeds 98 wt%, the amount of organic solvent that evaporates becomes extremely high, and the thickness of the film that is formed by a single round of solvent casting becomes extremely thin, thereby making it necessary to repeat the coating and solvent evaporation steps several times in order to form a film having suitable thickness, which reduces productivity. The organic solvent content is more preferably 60 to 90 wt%.

For compounding the fumaric acid diester resin composition into a substrate such as glass fiber, a coupling agent may be blended into the resin composition. Adhesion between the resin and base material can be improved by adding a coupling agent like a silane coupling agent.

Examples of such coupling agents used can be suitably selected from among silane coupling agents, titanate coupling agents, aluminum coupling agents and zircoaluminate agents according to the properties of the base material.

The following provides an explanation of the production process of fumaric acid diester resin composition.

First, a mixed solution containing a resin having at least one kind of fumaric acid diester, an organic solvent and an organic peroxide is prepared. Preparation of this mixed solution is usually carried out by dissolving a fumaric acid diester resin in an organic solvent and sequentially adding an organic peroxide to the solution. The organic peroxide is prepared in advance in the form of an organic peroxide solution. Then, a resin solution is mixed in the organic peroxide solution.

Next, the organic solvent of the mixed solution (fumaric acid diester resin composition) is evaporated. The resulting dried uncross-linked fumaric acid diester resin composition is then heated.

A radical reaction proceeds due to this heating resulting in the formation of bonds between polymer chains (cross-linking). As a result, cross-linked fumaric acid diester resin is formed. In comparison with the fumaric acid diester resin prior to cross-linking, this cross-linked product not only has improved heat resistance, but also improved solvent resistance and chemical resistance, while its performance as an electronic material, in terms of adhesion, mechanical characteristics and so forth, is further improved.

By performing this heating process at a predetermined temperature and for a predetermined period of time, the organic solvent is evaporated and removed. In addition, the organic peroxide is decomposed by this heating to form radicals, and these radicals cause the hydrogen abstraction reaction. As a result, the cross-linking reaction progresses. Thus, this heating process includes two steps: (1) evaporation of the solvent and uniform dispersal of organic peroxide, and (2) abstraction of hydrogen atoms of the side chains or main chain of the polyfumaric acid diester resin by the decomposition product of the organic peroxide, which results in cross-linking.

In order to obtain a smooth and uniform film, and to ensure optimum values for the residual amount of solvent in the cross-linked resin film and the residual stress and viscoelasticity of the film, the organic solvent evaporation rate is controlled by a heating program having the optimum heating temperature and heating time.

The heating temperature is usually 40 to 250°C, preferably 80 to 200°C. If the heating temperature is lower than 40°C, productivity decreases due to the slow solvent evaporation rate, while if the heating temperature exceeds 250°C, the evaporation rate is too fast making it difficult to produce a smooth and uniform film.

With respect to the treatment temperature, the solvent remains in the product when the heating time is insufficient. The presence of residual solvent changes the product dimensions and shape. In addition, if the heating time is insufficient, the decomposition of organic peroxide is inadequate. As a result, the resin is not adequately cross-linked, which reduces the solvent resistance of the product.

On the other hand, when the heating time is too long, the resulting film deteriorates easily and cracks are easily generated in the film. If the heating temperature exceeds 250°C in particular, since the polyfumaric acid diester resin is susceptible to oxidation, the resulting film has low heat resistance and mechanical strength.

When forming a resin film from the fumaric acid diester resin composition, after uniformly dissolving the fumaric acid diester resin and organic peroxide in a common solvent, the mixture is coated onto a sheet-shaped base material. Next, the solvent is evaporated and an untreated film is temporarily produced that does not have solvent resistance or chemical resistance. This untreated film is then heated to obtain a resin film having both solvent resistance and chemical resistance. The thickness of the resin film obtained in this manner (preferably 1µm to 5mm) is set by adjusting the concentration of the resin solution and the coating film thickness.

A resin film having a film thickness in excess of 5mm is obtained by repeating the above-mentioned coating and solvent evaporation and heating to form a plurality of coating layers until the desired total film thickness is attained. If the film thickness is 10µm or less, the film should be heated at 100°C or higher for 30 minutes or more. If the film thickness is 50µm or more, it is desirable that the film be heated at a low temperature for a long period of time (e.g., at 80°C or lower for 30 minutes or more) to avoid the occurrence of whitening and air bubbles (voids) in the coated film. It may also be effective to perform heat pressing and so forth at this time as necessary.

Glass such as borosilicate glass, quartz and glass sheet, metal substrates such as copper, aluminum, silicon wafers and stainless steel, cured resin sheets such as phenol resin sheets, and heat-resistant sheets such as fluorine resin sheets and silicone resin sheets can be used for the sheet-shaped base material.

To produce a cured resin in the form of a sheet or block having a thickness of 3mm or more, a sheet or block of the desired thickness is produced by repeating the above-mentioned coating and solvent evaporation. Next, a resin sheet or resin block can be produced having solvent and chemical resistance by sufficiently heating the resulting sheet or block. However, if the thickness exceeds 5 mm, the solvent evaporation rate decreases significantly and thermal conductivity also decreases. Consequently, the formation of cross-link between the resins is insufficient. Thus, in the case of producing a relatively thick resin sheet or resin block, a plurality of untreated films having a thickness of about 1mm are prepared in advance. The plurality of untreated films are heated to prepare resin films in which a plurality of cross-link are formed in the resins. The fumaric acid diester resin composition is then thinly coated onto each of the plurality of resin films. Next, the plurality of resin films are laminated until the required thickness is reached. After adequately evaporating the organic solvent, the resin film aggregate is sufficiently heated to cause cross-linking. As a result, a relatively thick resin sheet or resin block can be produced.

To produce a glass cloth impregnated with a fumaric acid diester resin composition, glass cloth is immersed in a solution of the fumaric acid diester resin composition. Next, the organic solvent remaining in the glass cloth is evaporated, followed by heating of the glass cloth. Then, a fumaric acid diester resin-glass cloth composite film is obtained having solvent and chemical resistance. The resulting composite film has a thickness of 10µm or more, and preferably 50µm or more. In addition, adhesion between the cross-linked fumaric acid diester resin and the glass cloth in the composite film is satisfactory.

To produce a sheet or block having a thickness of lmm or more, a fumaric acid diester resin is coated onto a plurality of fumaric acid diester resin-glass cloth composite films. Next, after laminating the plurality of composite films, the laminate is heated.

The thickness of the above-mentioned glass cloth is about 10 to 200µm, preferably about 20 to 100µm. It is difficult to produce a glass cloth having a thickness of less than 10µm. On the other hand, a glass cloth having a thickness in excess of 200µm is undesirable for the reasons described below. When impregnating a glass cloth with fumaric acid diester resin, air bubbles tend to enter easily, which creates voids. As a result, the smoothness of the surface of the resulting compound is poor. This composite film causes a delay in the signal transmission rate, particularly in the high-frequency bands. In addition, the dielectric constant and dielectric loss tangent vary widely in the film.

The ratio of the impregnated fumaric acid diester resin composition to the glass cloth can be selected according to the purpose, and should be within the range of 50 to 90 wt% relative to the entire composite film. If the impregnated amount is less than 50 wt%, the surface of the composite film is no longer smooth, and the mechanical characteristics and dielectric characteristics of the composite film are inadequate. On the other hand, if the ratio of impregnated resin composition exceeds 90 wt%, it becomes difficult to produce the composite film. In addition, the mechanical characteristics of such composite film are extremely low.

The preferred impregnation ratio of resin composition is 65 to 85 wt%. Glass cloth obtained by twill-weave of E glass or D glass fiber is preferred from the viewpoint of electrical characteristics. Glass cloth made of D glass is optimal when applied to copper-clad substrates for high-frequency use. Here, E glass refers to borosilicate glass having an alkali content of 1% or less and a silicon dioxide (SiO₂) content of 65% (dielectric constant ε=7.23, dielectric loss tangent tan 6 = 0.0011 (1 MHz)). D glass refers to glass having a higher content of silicon dioxide compared with E glass (73%) while also having a lower dielectric constant and dielectric loss tangent (dielectric constant ε= 4.74, dielectric loss tangent tan δ = 0.0009 (1 MHz)).

When producing this composite film, a coupling agent can be used as necessary for improving adhesion between the resin and the base material. Examples of coupling agents that can be used include silane-based, titanate-based, aluminum-based and zircoaluminum-based coupling agents.

Impregnation into glass fibers and so forth is performed by immersion (dipping), coating or other methods. Impregnation can be repeated several times as necessary, and impregnation can be repeated using a plurality of solutions having different compositions and concentrations. In addition, resin-impregnated glass composite sheets may also be adhered together by laminating a plurality of sheets.

A multilayer substrate can be produced by laminating an electrically conductive film made of a metal such as copper foil either between a plurality of composite films or on the outermost layer of composite film. In this case, copper foil, for example, is laminated (contact bonded) onto the composite film prior to removing the organic solvent. As a result of evaporating the solvent and then heating, a copper-clad substrate having low dielectric characteristics, heat resistance, solvent resistance and chemical resistance, can be obtained.

When forming a circuit pattern on a copper-clad substrate, photosensitive resin (photoresist) is coated onto the surface of, for example, a copper-clad substrate laminated with copper foil. Next, a circuit pattern mask is placed on the photosensitive resin. The mask is irradiated with ultraviolet rays (exposure step). The uncured portion of the photosensitive resin is then removed with a solvent, etc. (development step). Next, the area where resist is not formed is etched with an aqueous iron(III) chloride solution to form a circuit.

In a different method, the fumaric acid diester resin composition is coated on the back side of an insulating film on which a circuit pattern is formed. Next, the film is laminated to a resin-impregnated composite sheet, followed by heating. Then, a copper-clad substrate having a circuit pattern is obtained.

In a further method, a metal conductive film is affixed using an adhesive to an electrically insulating film from which the solvent has been removed. If it is necessary to form a pattern in the metal conductive film, pattern formation may be performed either before or after affixing the film.

In addition, a coated film can also be formed by coating the fumaric acid diester polymer onto a resin film substrate such as polyethylene terephthalate (PET). In this case, a coated film having a thickness of 1µm or more is obtained. Coated films having a thickness of about 500µm can be obtained by adjusting the concentration of coated solvent. A coated film can also be formed on a substrate subjected to vacuum deposition of ITO, which is a conductive layer of indium oxide (InO₂)-tin oxide (SnO₂), on the surface of PET or the like.

Known methods can be used for coating the polymer composition. For example, doctor blade coating, spin coating, dip coating, screen printing and gravure printing can be used.

The following effects are obtained according to the embodiment described above.

With the fumaric acid diester resin composition of the present invention, the resulting cross-linked products have a low dielectric constant. In addition, the dielectric loss of the cross-linked products is also low. Thus, the electrical insulating properties of the cross-linked products are excellent. This is believed to be due to the reasons indicated below.

The fumaric acid diester resin is a polymer formed from a monomer having as its main component fumaric acid diester. An alkyloxycarbonyl group or a cycloalkyloxycarbonyl group having polarity (dipole moment) is bonded as substituent groups to all of the polymethylene carbon atoms that comprise the main chain of the resin. Since these substituent groups exist in mutually trans positions, the dipole moment of the substituent groups is mutually canceled out. As a result, the resulting resin has a low dielectric constant.

Since the fumaric acid diester resin is a polymer containing ester groups having polarity, its dielectric loss is thought to be large in the same manner as methacrylate resin or acrylate resin. However, since the ester carbonyl groups are covered with bulky alkyl groups or cycloalkyl groups, moisture, which has a significant effect on dielectric loss, is inhibited from being adsorbed to the ester carbonyl groups. Consequently, the resulting resin has low dielectric loss.

According to the fumaric acid diester resin composition of the present embodiment, an organic peroxide generates primary radicals by thermal decomposition. Hydrogens present in the main chain or side chains of the polymer are abstracted by these primary radicals resulting in the generation of polymer radicals. These resulting polymer radicals then rebond with each other to form a cross-linked structure. Consequently, the resulting cross-linked products maintain their heat resistance having improved solvent resistance and resistance to chemicals such as acids and alkalis.

With the cross-linked fumaric acid diester resin of the present invention, by evaporating the organic solvent present in the fumaric acid diester resin composition and heating the residue, a cross-linked product can be easily and reliably obtained that is free of voids and cracks and variations in electrical characteristics.

Using the cross-linked fumaric acid diester resin of the present invention, after impregnating the fumaric acid diester resin composition in a glass cloth, evaporating the organic solvent and heating the impregnated glass cloth, a composite film having a cross-linked structure (composite) can be easily produced.

After impregnating the fumaric acid diester resin composition into a glass cloth, laminating a metal conductive film onto the glass cloth, and evaporating the organic solvent, by further heating the laminated glass cloth, a composite having a cross-linked structure can be easily produced.

The cross-linked fumaric acid diester resin of the present invention is useful as an insulating material and especially as a printed wiring board insulating material, a printed wiring board impregnation resin, an insulating varnish, an electronic component insulation coating material and electronic component potting material.

The following provides a detailed description of the present embodiment based on its examples and comparative examples. However, the present invention is not limited to the following examples.

### Example 1 and Comparative Example 1

Dicyclohexyl polyfumarate (PDcHF) having a weight average molecular weight of approximately 700,000 was dissolved in toluene to prepare a 10 wt% resin solution. Dicumyl peroxide (NOF Corporation, product name: Percumyl D) was added to the resin solution to a concentration of 3.0 wt% and 5.0 wt% relative to PDcHF. After uniformly mixing the resin solution, the mixed solution (varnish) was coated to a thickness of 100µm using a doctor blade onto a polyethylene terephthalate film having a thickness of 25µm. The toluene was then evaporated at room temperature for 24 hours. The film was dried for 5 hours in a vacuum. As a result, a film sample having a thickness of approximately 10µm was obtained.

The resulting film was cut into a plurality of film pieces. Each film piece was heated at 120°C, 140°C, 150°C and 180°C, respectively, for a predetermined amount of time using a hot air dryer to allow the cross-linking reaction to proceed by thermal decomposition of dicumyl peroxide (DCP). The conditions are summarized in Table 1.

The solubility of the heated film pieces was evaluated by observing the manner in which the film dissolved in toluene.

Separate from the above, the above-mentioned varnish was placed in a flat petri dish and the toluene was evaporated at room temperature to obtain a film having a thickness of approximately 1.2 mm. The film was cut into pieces in the shape of samples for measurement of electrical characteristics. The pieces were completely vacuum dried.

The dried pieces were heated at 160°C for 3 hours to induce the cross-linking reaction. Next, high-frequency electrical characteristics (dielectric constant and Q value) were measured using a cavity-resonating compound dielectric constant measuring apparatus. The measurement frequency was 2 GHz. In addition, dielectric constant, Q value, soldering heat resistance and solvent resistance were investigated in the manner described below. Those results are summarized in Table 2.

Dielectric constant: The sample (dielectric material) was inserted between the electrodes of a condenser followed by measurement of capacitance C. The dielectric constant is the ratio C/C₀ between that capacitance C and capacitance C₀ in the case of a vacuum.

Q value: Inverse of dielectric loss tangent (tan δ), namely the value of 1/tan δ.

Soldering heat resistance: A plate-shaped sample was immersed or floated in a molten solder bath at 260°C followed by observation of deformation, discoloration or decomposition of the sample. Cases where a sample was observed to be free of deformation, discoloration and decomposition are indicated with the mark ○, while cases where a sample was observed to demonstrate deformation, discoloration or decomposition are indicated with the mark ×. The contact time with the soldering bath is also shown.

Solvent resistance: A heated film sample was immersed in toluene and stirred at room temperature for 5 minutes. Then, the status of the film sample was observed. Cases where there was no change whatsoever observed in the sample are indicated with the mark ○, cases where a sample swelled or the sample dissolved are indicated with the mark ×.

### Example 2

Di-t-butyl peroxide (Perbutyl D), t-butyl-cumyl peroxide (Perbutyl C), α, α'-bis(t-butylperoxy-m-isopropyl)-benzene (Perbutyl P), 2,5-dimethyl-2,5-di(t-butylperoxy)-hexane (Perhexa 25B) and 2,5-dimethyl-2,5-di(t-butylperoxy)-hexyne-3 (Perhexyne 25B) were used instead of dicumyl peroxide (Percumyl D). The amount of each peroxide (PO) added was 3 wt% each relative to the amount of PDcHF. The heating temperatures and heating times were as shown in Table 3. Other conditions and experimental procedures were the same as Example 1. Those results are summarized in Table 4.

### Examples 3 to 26

The fumaric acid diester resins shown in Table 5 were used instead of PDcHF and Perbutyl D. The two kinds of monomers shown in Table 5 were used in Examples 16 to 26. Heating was performed under the conditions shown in Table 5. The properties of the resulting films were investigated, and those results are summarized in Table 6.

The abbreviations in Tables 5 and 6 refer to the compound names indicated below, and the letter P in front of the abbreviations represents "poly-".
- iPsBF:: Isopropyl-s-butyl fumarate
- iPcHF:: Isopropyl-cyclohexyl fumarate
- sBcHF:: s-Butylcyclohexyl fumarate
- iPcPF:: Isopropylcyclopentyl fumarate
- sBcPF:: s-Butylcyclopentyl fumarate
- iBcPF:: Isobutylcyclopentyl fumarate
- iBcHF:: Isobutylcyclohexyl fumarate
- iP4MPF:: Isopropyl-4-methyl-2-pentyl fumarate
- 4MPcHF:: 4-Methyl-2-pentylcyclohexyl fumarate
- sAcPF:: s-Amylcyclopentyl fumarate
- DnBF:: Di-n-butyl fumarate
- DsBF:: Di-s-butyl fumarate
- DcPF:: Dicyclopentyl fumarate
- DiBF:: Diisobutyl fumarate
- D4MPF:: Di-4-methyl-2-pentyl fumarate

### Comparative Examples 2 to 6

PD4MPF, P(DiBF-DiPF), P(DnBF-DiPF), P(DnBF-DsBF) and P(DnBF-DcHF) were used instead of PDcHF. An organic peroxide was not added. The samples were heated at 180°C for 3 hours. The properties of the resulting films were investigated, and those results are summarized in Tables 7 and 8.

As is shown in Tables 2, 4 and 6, all of the films of Examples 1 to 26 demonstrated low dielectric constants, low overall dielectric loss tangent and excellent soldering heat resistance and solvent resistance. In contrast, as shown in Tables 2 and 8, the films of Comparative Examples 1 to 6 (uncross-linked samples) demonstrated poor soldering heat resistance and solvent resistance in particular.

While the embodiments of the invention have been described, the invention is not limited thereto but can be modified within the scope of the appended claims and their equivalents.

**Table 1**

| | Polyfumarate | Peroxide(PO) | Addition ratio of PO/wt% | Heating temperature and period |
|---|---|---|---|---|
| Comp.Ex.1 | PDcHF | Percumyl D | 0 | ― |
| Ex.1a | PDcHF | Percumyl D | 3.0 | 180°C, 3hr |
| Ex.1b | PDcHF | Percumyl D | 5.0 | 180°C, 3hr |

**Table 2**

| | Dielectric constant | Q value | Soldering heat resistance | Solvent resistance |
|---|---|---|---|---|
| Comp.Ex.1 | 2.23 | 373 | ○ | × |
| Ex.1a | 2.57 | 368 | ○ | ○ |
| Ex.1b | 2.54 | 372 | ○ | ○ |

**Table 3**

| | Polyfumarate | Peroxide(PO) | Addition ratio of PO/wt% | Heating temperature and period |
|---|---|---|---|---|
| Ex.2a | PDcHF | Perbutyl D | 3.0 | 100°C, 5hr |
| Ex.2b | PDcHF | Perbutyl C | 3.0 | 120°C, 5hr |
| Ex.2c | PDcHF | Perbutyl P | 3.0 | 150°C,5hr |
| Ex.2d | P(DcHF) | Perhexa 25B | 3.0 | 150°C,4hr |
| Ex.2e | P(DcHF) | Perhexyne 25B | 3.0 | 180°C, 3hr |

**Table 4**

| | Dielectric constant | Q value | Soldering heat resistance | Solvent resistance |
|---|---|---|---|---|
| Ex.2a | 2.23 | 385 | ○ | ○ |
| Ex.2b | 2.26 | 385 | ○ | ○ |
| Ex.2c | 2.4 | 385 | ○ | ○ |
| Ex.2d | 2.41 | 264 | ○ | ○ |
| Ex.2e | 2.66 | 276 | ○ | ○ |

**Table 5**

| | Polyfumarate | Peroxide(PO) | Addition ratio of PO/wt% | Heating temperature and period |
|---|---|---|---|---|
| Ex.3 | PDcHF | Perbutyl D | 3.0 | 100°C, 5hr |
| Ex.4 | PDcHF | Perbutyl C | 3.0 | 120°C, 5hr |
| Ex.5 | PDcHF | Perbutyl D | 3.0 | 150°C,5hr |
| Ex.6 | P(iPsBF) | Perbutyl P | 3.0 | 150°C,5hr |
| Ex.7 | P(iPcHF) | Perhexa 25B | 3.0 | 180°C,3hr |
| Ex.8 | P(sBcPF) | Perhexyne 25B | 3.0 | 180°C,3hr |
| Ex.9 | P(iPcPF) | Perbutyl P | 3.0 | 150°C,4hr |
| Ex.10 | P(sBcPF) | Perhexyne 25B | 3.0 | 180°C,3hr |
| Ex.11 | P(iBcPF) | Perbutyl P | 3.0 | 150°C,4hr |
| Ex.12 | P(iBcPF) | Perhexyne 25B | 3.0 | 180°C, 3hr |
| Ex.13 | P(iP4MPF) | Percumyl D | 3.0 | 180°C, 3hr |
| Ex.14 | P(4MPcHF) | Perbutyl P | 3.0 | 150°C,4hr |
| Ex.15 | P(sAcPF) | Percumyl D | 3.0 | 180°C,3hr |
| Ex.16 | P(DnBF-DiPF) | Perhexyne 25B | 3.0 | 180°C,3hr |
| Ex.17 | P(DnBF-DiPF) | Perhexyne 25B | 3.0 | 180°C,3hr |
| Ex.18 | P(DsBF-DiPF) | Perbutyl D | 3.0 | 150°C,3hr |
| Ex.19 | P(DsBF-DcPF) | Percumyl D | 3.0 | 180°C,3hr |
| Ex.20 | P(DsBF-DcHF) | Perhexa 25B | 3.0 | 180°C, 3hr |
| Ex.21 | P(DiBF-DcPF) | Perhexyne 25B | 3.0 | 180°C,3hr |
| Ex.22 | P(DiBF-DcHF) | Percumyl D | 3.0 | 180°C,3hr |
| Ex.23 | P(D4MP-DcPF) | Perbutyl P | 3.0 | 150°C,4hr |
| Ex.24 | P(D4MPF-DcHF) | Perhexa 25B | 3.0 | 180°C,3hr |
| Ex.25 | P(DiPF-DcPF) | Perhexyne 25B | 3.0 | 180°C,3hr |
| Ex.26 | P(DiPF-DcHF) | Perhexa 25B | 3.0 | 180°C,3hr |

**Table 6**

| | Dielectric constant | Q value | Soldering heat resistance | Solvent resistance |
|---|---|---|---|---|
| Ex.3 | 2.23 | 377 | ○ | ○ |
| Ex.4 | 2.26 | 382 | ○ | ○ |
| Ex.5 | 2.41 | 392 | ○ | ○ |
| Ex.6 | 2.43 | 264 | ○ | ○ |
| Ex.7 | 2.84 | 286 | ○ | ○ |
| Ex.8 | 2.79 | 253 | ○ | ○ |
| Ex.9 | 2.34 | 240 | ○ | ○ |
| Ex.10 | 2.21 | 244 | ○ | ○ |
| Ex.11 | 2.41 | 318 | ○ | ○ |
| Ex.12 | 2.38 | 288 | ○ | ○ |
| Ex.13 | 2.45 | 250 | ○ | ○ |
| Ex.14 | 2.66 | 190 | ○ | ○ |
| Ex.15 | 2.67 | 186 | ○ | ○ |
| Ex.16 | 2.86 | 256 | ○ | ○ |
| Ex.17 | 2.66 | 238 | ○ | ○ |
| Ex.18 | 2.38 | 245 | ○ | ○ |
| Ex.19 | 2.31 | 213 | ○ | ○ |
| Ex.20 | 2.49 | 221 | ○ | ○ |
| Ex.21 | 2.45 | 196 | ○ | ○ |
| Ex.22 | 2.51 | 267 | ○ | ○ |
| Ex.23 | 2.46 | 253 | ○ | ○ |
| Ex.24 | 2.60 | 284 | ○ | ○ |
| Ex.25 | 2.54 | 264 | ○ | ○ |
| Ex.26 | 2.64 | 264 | ○ | ○ |

**Table 7**

| | Polyfumarate | Peroxide(PO) | Addition ratio of PO/wt% and | Heating temperature period |
|---|---|---|---|---|
| Comp.Ex.2 | P(D4MPF) | ― | 0 | ― |
| Comp.Ex.3 | P(DiBF-DiPF) | ― | 0 | ― |
| Comp.Ex.4 | P(DnBF-DiPF) | ― | 0 | ― |
| Comp.Ex.5 | P(DsBF-DiBF) | ― | 0 | ― |
| Comp.Ex.6 | P(DnBF-DcHF) | ― | 0 | ― |

**Table 8**

| | Dielectric constant | Q value | Soldering heat resistance | Solvent resistance |
|---|---|---|---|---|
| Comp.Ex.2 | 2.54 | 226 | × | × |
| Comp.Ex.3 | 2.48 | 176 | × | × |
| Comp.Ex.4 | 2.36 | 155 | × | × |
| Comp.Ex.5 | 2.49 | 170 | × | × |
| Comp.Ex.6 | 2.36 | 233 | × | × |

## Claims

1. A fumaric acid diester resin composition **characterized by** a polymer derived from at least one kind of fumaric acid diester monomer, an organic peroxide and an organic solvent.

2. The composition according to claim 1, **characterized in that** the fumaric acid diester monomer is a compound represented by the following chemical formula: 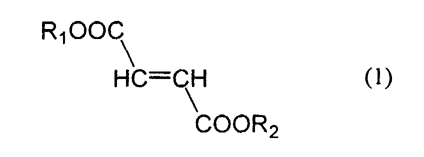 wherein R₁ represents a branched alkyl group or a cycloalkyl group having 3 to 18 carbon atoms, and R₂ represents an alkyl group, a cycloalkyl group or an aryl group having 3 to 18 carbon atoms.

3. The composition according to claim 2, **characterized in that** the branched alkyl group of the R₁ or R₂ has a substituent group containing at least one of halogen group and alkoxy group.

4. The composition according to claim 2, **characterized in that** at least one of the R₁ and R₂ is a cycloalkyl group, and the cycloalkyl group contains at least one of cyclopentyl group, cyclohexyl group, bornyl group, isobornyl group, adamantyl group and dimethyladamantyl group.

5. The composition according to claim 2, **characterized in that** at least one of the R₁ and R₂ is a cycloalkyl group having a substituent group.

6. The composition according to claim 2, **characterized in that** the R₂ is an aryl group, and the aryl group contains at least one of phenyl group, 4-methylphenyl group and 4-tert-butylphenyl group.

7. The composition according to claim 1, **characterized in that** the polymer is a copolymer of plural kinds of fumaric acid diester monomers.

8. The composition according to claim 1, **characterized in that** the polymer is a copolymer of at least one kind of fumaric acid diester monomer and a vinyl monomer.

9. The composition according to claim 1, **characterized in that** the 10-hour half-life temperature of the organic peroxide is 30 to 230°C.

10. The composition according to claim 1, further **characterized by** a coupling agent for enhancing adhesion of the composition to a predetermined base material.

11. A process for preparing a cross-linked fumaric acid diester resin **characterized by** the steps of:
preparing a composition containing a polymer having at least one kind of fumaric acid diester monomer (fumaric acid diester resin), an organic peroxide and an organic solvent,
evaporating the organic solvent; and
heating the product obtained in the evaporation step.

12. The process according to claim 11 further **characterized by** coating the composition onto a predetermined base material to obtain a cross-linked film, prior evaporating the organic solvent.

13. The process according to claim 12 further **characterized by** repeating the coating and the evaporating to obtain a cross-linked film having a predetermined thickness.

14. The process according to claim 12 further **characterized by:**
repeating the coating step and the evaporating step to obtain a plurality of cross-linked films;
thin-coating the fumaric acid diester resin composition onto each of a plurality of cross-linked films;
laminating the plurality of cross-linked films to form a cross-linked film aggregate of a required thickness;
evaporating the organic solvent from the cross-linked film aggregate; and
heating the cross-linked film aggregate.

15. A process for preparing a composite having a cross-linked fumaric acid diester resin, the process **characterized by** the steps of:
preparing a composition containing a polymer having at least one kind of fumaric acid diester monomer (fumaric acid diester resin), an organic peroxide and an organic solvent;
bringing a predetermined base material into contact with the composition to make the base material retain the composition thereon;
evaporating the organic solvent from the base material on which the composition is retained; and
heating the base material on which the composition is retained.

16. The process according to claim 15 further **characterized by** laminating an electrically conductive film onto the glass cloth, prior to the evaporating the organic solvent.
